# EUROPEAN PATENT SPECIFICATION

(11) **EP 0 346 625 B1**
(45) Date of publication and mention of the grant of the patent: **27.11.1996**
(21) Application number: 89108759.5
(22) Date of filing: 16.05.1989
(51) Int. Cl.: H01L 21/76

(54) **Method of forming a semiconductor integrated circuit having isolation trenches**
Verfahren zur Herstellung eines integrierten Halbleiterschaltkreises mit Isolationsgräben
Procédé de fabrication d'un circuit integré à semiconducteur ayant des sillons d'isolation

(30) Priority: 17.05.1988 JP 118304/88
(43) Date of publication of application: 20.12.1989
(73) Proprietor: KABUSHIKI KAISHA TOSHIBA, Kawasaki-shi (JP)
(72) Inventor: Hirakawa, Kenji Intellectual Property Division, Minato-ku Tokyo 105 (JP)
(74) Representative: Lehn, Werner, Dipl.-Ing.

(56) References cited:
- WO-A-82/02283
- WO-A-83/04343
- FR-A- 2 030 843
- US-A- 4 009 484
- IEEE TRANSACTIONS ON ELECTRON DEVICES vol. ED-34, no. 11, November 1987, pages 2246-2254, New York, US; G.P. LI et al.: "An Advanced High- Performance Trench-Isolated Self-Aligned Bipolar Technology"

## Description

The present invention relates to a method of forming a semiconductor device, and particularly to a bipolar transistor integrated circuit of the type in which a trench isolation is used for elements separation. More particularly, the present invention relates to a method of forming an integrated circuit for an analog circuit that is used for a high speed logic operation or operable at high frequencies.

Recently, the technical field of the semiconductor devices, particularly bipolar integrated circuits, which are constantly under pressures to increase an integration density and to improve the performances, has begun to use a technique to isolate semiconductor elements from one another, that is called a trench isolation.

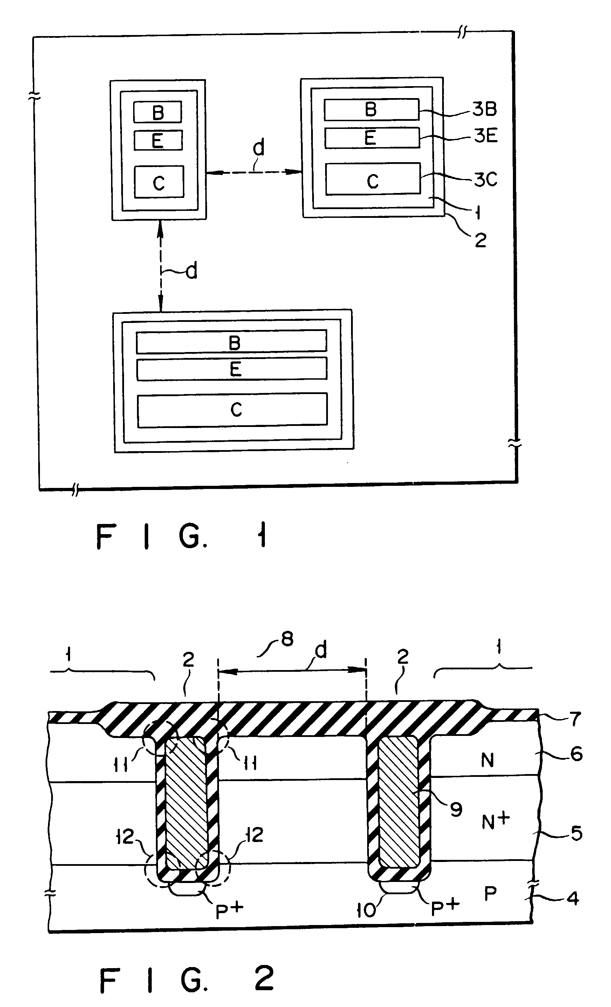

A typical bipolar integrated circuit fabricated by using the trench isolation will be described with reference to Fig. 1 showing a plan view of a part of its structure including elements, trenches, and the like. As is shown, a plurality of element forming regions 1 are each enclosed by trenches 2. A base contact 3B, emitter contact 3E, and collector contact 3C are laid out on the top of each element forming area 1. The adjacent trenches 2 are separated by a distance "d" from each other.

A sectional view of the structure whose top is thus laid out is shown in Fig. 2. As is shown, the side wall of each element forming region 1 is defined by the trench 2. An N⁺ collector buried layer 5 and an N type epitaxial layer 6 are layered on a P type semiconductor substrate 4 in this order. An SiO₂ film 7 is laid over the surface of the structure containing the element forming regions 1 and the trenches 2, and covers the inner wall of each trench 2. Each trench 2 is filled with polysilicon film 9. A P⁺ type channel cut layer 10 is formed in contact with the outside of the SiO₂ film 7 at the bottom of each trench 2.

In designing the above type of the integrated circuits, a designer must devote a great care to the distance "d" between the adjacent trenches 2. In the structure of the integrated circuit as is shown in Figs. 1 and 2, a great stress is applied to the corners 11 and 12 of the SiO₂ film 7 as indicated by dotted line circles, possibly causing crystal defects. For example, if the intertrench distance "d" is set at 2 µm or less, the stress is concentrically applied to the corners, so that many crystal defects are caused and consequently a production yield is remarkably reduced in the production of the semiconductor devices. As a matter of course, the occurrence of such a phenomenon depends on the structure of trench and the manufacturing process used. In this case, to lessen the stress, the distance "d" must be broadened to be 5 to 10 µm, for example. To realize this, a complicated design work and an increase of the device geometry are necessitated.

Generally, a reactive ion etching using gas of CBrF₃, for example, is employed for forming the trenches for the trench isolation. This etching process have a great loading effect. Because of this, an etching rate depends on the areas of the trench. Therefore, in fabricating the semiconductor device, time-consuming works to obtain a required etching rate are needed, for example, to previously calculate the surface area of the trench in design stages or to etch the semiconductor structure for each type of the devices by using the same mask and to measure the depth of trench. The etching rate calculating work is an abstract to the mass production of many types of semiconductor devices.

An integrated circuit known from FR-A-2 030 843 comprises a plurality of small islands made from monocrystalline silicon and element forming regions which are surrounded by polycrystalline silicon. The polycrystalline silicon surrounding the element regions is formed in a lattice fashion and serves as an electrical isolation for the islands or element regions. In the different element regions transistors or the like are formed.

A further semiconductor device disclosed in US-A-4 009 484 has monocrystalline regions and polycrystalline regions which are arranged in the lattice-like manner for forming element regions in which circuit elements such as transistors can be provided.

A transistor with an advanced isolation known from IEEE Transactions on Electron Devices ED-34 (11), November 1987, pages 2246-2254, is formed on a semiconductor substrate and is isolated by a trench. A first polysilicon layer serving as a base electrode and a second polysilicone layer serving as an emitter electrode are formed on the substrate. The first polysilicon layer is used as a resistor.

Another semiconductor device disclosed in W083/04343 comprises a silicon chip having a first portion in which MOS-transistors are formed. A second portion of the silicon chip includes a polyoxid capacitor which is formed on a field oxide film, i.e. above an isolating region which is not used for forming transistors or the like.

The object of the present invention is to provide a method of producing a semiconductor device using a trench isolation for isolating elements, which reduces the complexity in design and manufacturing process, and improves an integration density.

According to the present invention this object is achieved by a method as defined in claim 1 or 2.

Further advantageous embodiments and improvements of the invention can be taken from the dependent claims.

This invention can be more fully understood from the following detailed description when taken in conjunction with the accompanying drawings, in which:
Fig. 1 is a plan view of a conventional integrated circuit formed using a trench isolation;
Fig. 2 is a sectional view of the integrated circuit of Fig. 1;
Fig. 3 is a plan view of a integrated circuit formed using a trench isolation produced according to an embodiment of a semiconductor device of the present invention; and
Fig. 4 is a sectional view of the integrated circuit of Fig. 3.

A specific embodiment of a method of forming a bipolar transistor integrated circuit as a semiconductor device according to the present invention will be described with reference to the accompanying drawings.

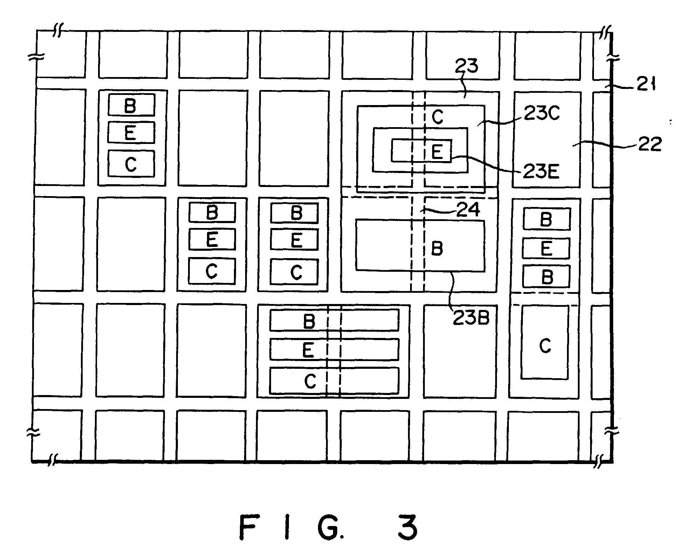

A layout of semiconductor elements and trenches in a bipolar transistor integrated circuit is shown in Fig. 3. As is shown, trenches 21 are laid out in a matrix or lattice fashion. Each block enclosed by trenches 21 defines an element forming region 22. It is designed that the size of the region 22 defines a minimum element. Accordingly, a distance between the adjacent trenches 21 is at least 10 µm. This reduces the possibility that the crystal defect occurs.

The above integrated circuit is designed and manufactured in the following manner. In circuit design, a designer selects element forming regions 22 separated by the trenches 21 in accordance with a circuit to be designed. As is shown, an element 23 having an emitter contact 23E, base contact 23B, and collector contact 23C, requires large areas each larger than an area of the element forming region 22 that is limited by the block of the trenches 21 arrayed in a matrix fashion. Such large area can obtained by removing a part 24 of the trench 21. The trenches defining the regions 22 where no element is formed are left as intact.

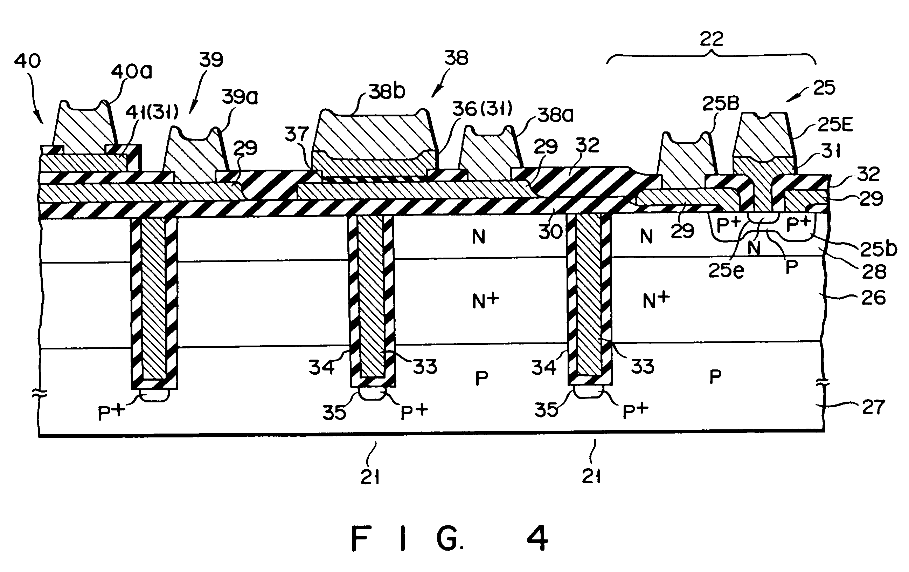

A cross section of the integrated circuit thus designed and manufactured is illustrated in Fig. 4. In the figure, an npn bipolar transistor 25 is formed in an element forming region 22. In the transistor 25, an n⁺ collector buried layer 26 is layered on a p-type semiconductor substrate 27. An n-type epitaxial layer 28 is layered on the collector buried layer 26. A base region 25b is formed in the n-type expitaxial layer 28. An emitter region 25e is formed in the base region 25b.

The base region 25b is connected to a base Aℓ (aluminum) lead 25B by a p-type polysilicon film 29 as a base region contact. The silicon film 29 is led out onto an SiO₂ film 30, such as the silicon film 29 is arrayed facing the SiO₂ film 30 through the collector region of the substrate. The base Aℓ lead 25B is formed on the silicon film 29. The silicon film 29 is doped with boron, for example.

The emitter region 25e is connected to an emitter Aℓ lead 25E by an n-type polysilicon film 31 as an emitter contact. In this case, an n-type polysilicon film 31 for an emitter contact is doped with arsenic, in this instance.

The base Aℓ lead 25B and the emitter Aℓ lead 2E are formed by coating with aluminum film and then patterning appropriately.

The trenches 21 are each filled with polysilicon film 33. A p⁺ channel cut layer 35 is downwardly formed on the bottom of an SiO₂ film 34 covering the polysilcion film 33.

In a region outside the element forming region 22 to which the p-type polysilicon film 29 extends, a dielectric layer 37 is interlaid between the p-type polysilicon film 29 and an n-type polysilicon film 36. These thus arranged cooperate to form a capacitance 38. The polysilicon film 29 is coated with a lower electrode 38a of the capacitor 38. An aluminum film is applied over the upper surface of the polysilicon film 36, and patterned, thereby to form an upper electrode 38b of the capacitor 38.

The structure of Fig. 4 contains a plurality of resistors 39 and 40. The resistor 39 is provided with a plurality of Aℓ leads (in this instance, only an Aℓ lead 39a is illustrated for simplicity) that are formed on P-type polysilicon film 29 by a patterning process and are parted by given distance. The resistor 40 is provided with a plurality of Aℓ leads (in this instance, only an Aℓ lead 40a is illustrated for simplicity) that are formed on an n-type polysilicon film 41 by a patterning process and are parted by given distance. These resistances 39 and 40 are stacked one upon the other.

As seen from the foregoing, the capacitors and resistors are formed on the trenches 21. Therefore, if the trenches are formed in even the regions where no elements are formed, an integration density may be improved.

As seen from the foregoing description, in the semiconductor device according to the present invention, the bipolar transistor integrated circuit is featured in that trenches are previously formed in a matrix fashion. With this feature, designers can make a pattern design not taking into account intertrench intervals. Further, differences of the etching rates among the different types of elements that arises from the loading effect at the time of etching for trench formation, may be minimized.

The n-type polysilicon films 36 and 41 may be the same polysilicon film 31 as formed in the same process. In other words, a high integration density of the npn bipolar integrated circuit can be attained by using two types of polysilicon films, one for leading out the base electrode and the other for leading out the emitter electrode.

## Claims

1. Method of forming a bipolar transistor integrated circuit comprising the following steps:
a) forming a plurality of insulating trenches (21) in a semiconductor substrate (27), said insulating trenches (21) enclosing semiconductor element forming regions (22) in a matrix fashion;
b) forming a silicon dioxide layer (30) on said substrate (27);
c) forming a bipolar transistor (25) in a first of said semiconductor element forming regions (22), said bipolar transistor (25) comprising a base region (25b) having a first conductivity type, and collector (26) and emitter (25e) regions having a second conductivity type;
d) forming a first polysilicon film (29) having said first conductivity type on said silicon dioxide layer (30), said first polysilicon layer (29) comprising a first portion above said first semiconductor element forming region (22) where said bipolar transistor (25) is formed contacting said base region (25b) via a first opening in said silicon dioxide layer (30) and a second portion outside said first semiconductor element forming region (22) and above one of said plurality of insulating trenches (21);
e) deposing a dielectric layer (37) on parts of said second portion of said first polysilicon film (29);
f) depositing a second polysilicon film (31) having said second conductivity type, said second polysilicon film (31) comprising a first portion above said first semiconductor element forming region (22), contacting said emitter region (25e) via a second opening in said silicon dioxide layer (30), and a second portion formed on said dielectric layer (37);
g) forming base (25B) and emitter (25E) leads connected to said first portions of said first and second polysilicon films (29, 31), respectively; and
h) forming a first electrode (38a) on an exposed part of said second portion of said first polysilicon film (29) and a second electrode (38b) on said second portion of said second polysilicon film (31), wherein said first and second electrodes (38a, 38b) cooperate to form a capacitor (38).

2. Method of forming a bipolar transistor integrated circuit comprising the following steps:
a) forming a plurality of insulating trenches (21) in a semiconductor substrate (27), said insulating trenches (21) enclosing semiconductor element forming regions (22) in a matrix fashion;
b) forming a silicon dioxide layer (30) on said substrate (27);
c) forming a bipolar transistor (25) in a first of said semiconductor element forming regions (22), said bipolar transistor (25) comprising a base region (25b) having a first conductivity type, and collector (26) and emitter (25e) regions having a second conductivity type;
d) forming a first polysilicon film (29) having said first conductivity type on said silicon dioxide layer (30), said first polysilicon layer (29) comprising a first portion above said first semiconductor element forming region (22) where said bipolar transistor (25) is formed contacting said base region (25b) via a first opening in said silicon dioxide layer (30), and a second portion outside said semiconductor element forming region (22) and above one of said plurality of insulating trenches (21);
e) depositing a dielectric layer (37) on parts of said second portion of said first polysilicon film (29);
f) depositing a second polysilicon film (31) having said second conductivity type, said second polysilicon film (31) comprising a first portion above said first semiconductor element forming region (22) contacting said emitter region (25e) via a second opening in said silicon dioxide layer (30), and a second portion formed on said dielectric layer (37);
g) forming base (25B) and emitter (25E) leads connected to said first portions of said first and second polysilicon films (29, 31), respectively; and
h) forming a plurality of spaced first electrodes (39a) on exposed parts of said second portion of said first polysilicon film (29) and a plurality of spaced second electrodes (40a) on said seccnd portion of said second polysilicon film (31), wherein said first and second plurality of electrodes (39a, 40a) contact first and second stacked resistances (39, 40) formed by the second portions of the first and second polysilicon films, respectively.

3. A method according to claim 2,
characterized in that
a) said first polysilicon film (29) comprises a third portion formed outside said semiconductor element forming region (22) above a further one of said insulating trenches (21);
b) said dielectric layer (37) is also formed on parts of said third portion of said first polysilicon film (29);
c) said second polysilicon film (31) comprises a third portion formed on said dielectric layer (37); and in that
d) a third electrode (38a) is formed on an exposed part of said third portion of said first polysilicon film (29), and a fourth electrode (38b) is formed on said third portion of said second polysilicon film (31), wherein said third and fourth electrodes (38a, 38b) cooperate to form a capacitor (38).

4. The method according to one of claims 1 to 3,
characterized by providing an intertrench interval which is equal to a predetermined minimum element size.

5. The method according to claim 4,
characterized in that said intertrench interval is approximately 10 µm.

6. The method according to claim 5,
characterized in that a semiconductor element of larger size than said minimum element size is formed by forming a plurality of adjacent element forming regions (22) between which an insulating trench (21) is not formed.

## Patentansprüche

1. Verfahren zur Herstellung einer integrierten Bipolartransistor-Schaltung, umfassend die folgenden Schritte:
a) Bilden einer Vielzahl von isolierenden Gräben (21) in einem Halbleitersubstrat (27), wobei die isolierenden Gräben (21) Halbleiterelement-Bildungsbereiche (22) in einer Matrixweise umgeben;
b) Bilden einer Siliziumdioxidschicht (30) auf dem Substrat (27);
c) Bilden eines Bipolartransistors (25) in einem ersten der Halbleiterelement-Bildungsbereiche (22), wobei der Bipolartransistor (25) einen Basisbereich (25b) mit einem ersten Leitfähigkeitstyp und Kollektor- (26) und Emitter- (25e) Bereiche mit einem zweiten Leitfähigkeitstyp umfaßt;
d) Bilden eines ersten Polysiliziumfilms (29) mit dem ersten Leitfähigkeitstyp auf der Siliziumdioxidschicht (30), wobei die erste Polysiliziumschicht (29) einen ersten Abschnitt über dem ersten Halbleiterelement-Bildungsbereich (22), an dem der Bipolartransistor (25) den Basisbereich (25b) über eine erste Öffnung in der Siliziumdioxidschicht (30) kontaktierend gebildet ist, und einen zweiten Abschnitt außerhalb des ersten Halbleiterelements-Bildungsbereichs (22) und über einem der Vielzahl von isolierenden Gräben (21) umfaßt;
e) Aufbringen einer dielektrischen Schicht (37) auf Teilen des zweiten Abschnitts des ersten Polysiliziumfilms (29);
f) Aufbringen eines zweiten Polysiliziumfilms (31) mit dem zweiten Leitfähigkeitstyp, wobei der zweite Polysiliziumfilm (31) einen ersten Abschnitt über dem ersten Halbleiterelement-Bildungsbereich (22), den Emitterbereich (25e) über eine zweite Öffnung in der Siliziumdioxidschicht (30) kontaktierend, und einen zweiten Abschnitt, der auf der dielektrischen Schicht (37) gebildet ist, umfaßt;
g) Bilden von Basis (25B)- und Emitter (25E)-Zuleitungen, die mit den ersten Abschnitten der ersten bzw. zweiten Polysiliziumfilme (29, 31) verbunden sind; und
h) Bilden einer ersten Elektrode (38a) auf einem freigelegten Teil des zweiten Abschnitts des ersten Polysiliziumfilms (29) und einer zweiten Elektrode (38b) auf dem zweiten Abschnitt des zweiten Polysiliziumfilms (31), wobei die ersten und zweiten Elektroden (38a, 38b) zusammenwirken, um einen Kondensator (38) zu bilden.

2. Verfahren zum Herstellen einer integrierten Bipolartransistor-Schaltung, umfassend die folgenden Schritte:
a) Bilden einer Vielzahl von isolierenden Gräben (21) in einem Halbleitersubstrat (27), wobei die isolierenden Gräben (21) Halbleiterelement-Bildungsbereiche (22) in einer Matrixweise umgeben;
b) Bilden einer Siliziumdioxidschicht (30) auf dem Substrat (27);
c) Bilden eines Bipolartransistors (25) in einem ersten der Halbleiterelement-Bildungsbereiche (22), wobei der Bipolartransistor (25) einen Basisbereich (25b) mit einem ersten Leitfähigkeitstyp und Kollektor- (26) und Emitter-(25e)Bereich mit einem zweiten Leitfähigkeitstyp umfaßt;
d) Bilden eines ersten Polysiliziumfilms (29) mit dem ersten Leitfähigkeitstyp auf der Siliziumdioxidschicht (30), wobei die erste Polysiliziumschicht (29) einen ersten Abschnitt über dem ersten Halbleiterelement-Bildungsbereich (22), an dem der Bipolartransistor (25) den Basisbereich (25b) über eine erste Öffnung in der Siliziumdioxidschicht (30) kontaktierend gebildet ist, und einen zweiten Abschnitt außerhalb des Halbleiterelement-Bildungsbereichs (22) und über einem der Vielzahl von isolierenden Gräben 21 umfaßt;
e) Aufbringen einer dielektrischen Schicht (37) auf Teilen des zweiten Abschnitts des ersten Polysiliziumfilms (29);
f) Aufbringen eines zweiten Polysiliziumfilms (31) mit dem zweiten Leitfähigkeitstyp, wobei der zweite Polysiliziumfilm (31) einen ersten Abschnitt über dem ersten Halbleiterelement-Bildungsbereich (22), der den Halbleiterbereich (25e) über eine zweite Öffnung in der Siliziumdioxidschicht (30) kontaktiert, und einen zweiten Abschnitt, der auf der dielektrischen Schicht (37) gebildet ist, umfaßt;
g) Bilden von Basis- (25B) und Emitter-(25E) Zuleitungen, die mit den ersten Abschnitten der ersten bzw. zweiten Polysiliziumfilme (29, 31) verbunden sind; und
h) Bilden einer Vielzahl von beabstandeten ersten Elektroden (39a) auf freigelegten Teilen des zweiten Abschnitts des ersten Polysiliziumfilms (29) und einer Vielzahl von beabstandeten zweiten Elektroden (40a) auf dem zweiten Abschnitt des zweiten Polysiliziumfilms (31), wobei die erste und zweite Vielzahl von Elektroden (39a, 40a) erste bzw. zweite aufgeschichtete Widerstände (39, 40), die durch die zweiten Abschnitte der ersten und zweiten Polysiliziumfilme gebildet sind, kontaktieren.

3. Verfahren nach Anspruch 2, dadurch gekennzeichnet, daß
a) der erste Polysiliziumfilm (29) einen dritten Abschnitt umfaßt, der außerhalb des Halbleiterelement-Bildungsbereichs (22) über einem weiteren der isolierenden Gräben (21) gebildet ist;
b) die dielektrische Schicht (37) auch auf Teilen des dritten Abschnitts des ersten Polysiliziumfilms (29) gebildet wird;
c) der zweite Polysiliziumfilm (31) einen dritten Abschnitt umfaßt, der auf der dielektrischen Schicht (37) gebildet ist; und daß
d) eine dritte Elektrode (38a) auf einem freigelegten Teil des dritten Abschnitts des ersten Polysiliziumfilms (29) gebildet ist, und eine vierte Elektrode (38b) auf dem dritten Abschnitt des zweiten Polysiliziumfilms (31) gebildet ist, wobei die dritten und vierten Elektroden (38a, 38b) zusammenwirken, um einen Kondensator (38) zu bilden.

4. Verfahren nach einem der Ansprüche 1 - 3, gekennzeichnet durch Vorsehen eines Grabenzwischenintervalls, welches einer vorgegebenen minimalen Elementgröße gleicht.

5. Verfahren nach Anspruch 4, dadurch gekennzeichnet, daß das Grabenzwischenintervall ungefähr 10 µm ist.

6. Verfahren nach Anspruch 5, dadurch gekennzeichnet, daß ein Halbleiterelement einer größeren Größe als die minimale Elementgröße durch Bilden einer Vielzahl von benachbarten Elementbildungsbereichen (22), zwischen denen ein isolierender Graben (21) nicht gebildet ist, gebildet wird.

## Revendications

1. Procédé de fabrication d'un circuit intégré à transistors bipolaires, comprenant les étapes consistant à:
a) former une pluralité de sillons isolants (21) dans un substrat de semiconducteur (27), lesdits sillons isolants entourant des régions de formation des éléments à semiconducteur (22) d'une façon matricielle;
b) former une couche de dioxyde de silicium (30) sur ledit substrat (27);
c) former un transistor bipolaire (25) dans une première desdites régions de formation des éléments à semiconducteur (22), ledit transistor bipolaire (25) comprenant une région de base (25b) ayant un premier type de conductibilité et des régions de collecteur (26) et d'émetteur (25e) ayant un deuxième type de conductibilité;
d) former une première couche de polysilicium (29) ayant ledit premier type de conductibilité sur ladite couche de dioxyde de silicium (30), ladite première couche de polysilicium (29) comprenant une première portion au-dessus de ladite première région de formation d'un élément à semiconducteur (22) où ledit transistor bipolaire (25) est formé, en contact avec ladite région de base (25b) par l'intermédiaire d'une première ouverture dans ladite couche de dioxyde de silicium (30) et une deuxième portion en dehors de ladite première région de formation d'un élément à semiconducteur (22) et au-dessus d'un sillon de ladite pluralité de sillons isolants (21);
e) déposer une couche diélectrique (37) sur des parties de ladite deuxième portion de ladite première couche de polysilicium (29);
f) déposer une deuxième couche de polysilicium (31) ayant ledit deuxième type de conductibilité, ladite deuxième couche de polysilicium (31) comprenant une première portion au-dessus de ladite première région de formation d'un élément à semiconducteur (22), en contact avec ladite région d'émetteur (25e) par l'intermédiaire d'une deuxième ouverture dans ladite couche de dioxyde de silicium (30), et une deuxième portion formée sur ladite couche diélectrique (37);
g) former des conducteurs de base (25B) et d'émetteur (25E) connectés auxdites premières portions desdites première et deuxième couches de polysilicium (29, 31), respectivement; et
h) former une première électrode (38a) sur une partie exposée de ladite deuxième portion de ladite première couche de polysilicium (29) et une deuxième électrode (38b) sur ladite deuxième portion de ladite deuxième couche de polysilicium (31), lesdites première et deuxième électrodes (38a, 38b) coopérant pour former un condensateur (38).

2. Procédé de fabrication d'un circuit intégré à transistors bipolaires, comprenant les étapes consistant à:
a) former une pluralité de sillons isolants (21) dans un substrat de semiconducteur (27), lesdits sillons isolants (21) entourant des régions de formation des éléments à semiconducteur (22) d'une façon matricielle;
b) former une couche de dioxyde de silicium (30) sur ledit substrat (27);
c) former un transistor bipolaire (25) dans une première desdites régions de formation des éléments à semiconducteur (22), ledit transistor bipolaire (25) comprenant une région de base (25b) ayant un premier type de conductibilité, et des régions de collecteur (26) et d'émetteur (25e) ayant un deuxième type de conductibilité;
d) former une première couche de polysilicium (29) ayant ledit premier type de conductibilité sur ladite couche de dioxyde de silicium (30), ladite première couche de polysilicium (29) comprenant une première portion au-dessus de ladite première région de formation d'un élément à semiconducteur (22) où ledit transistor bipolaire (25) est formé, en contact avec ladite région de base par l'intermédiaire d'une première ouverture dans ladite couche de dioxyde de silicium (30), et une deuxième portion à l'extérieur de ladite région de formation d'un élément à semiconducteur (22) et au-dessus d'un sillon de ladite pluralité de sillons isolants (21);
e) Déposer une couche diélectrique (37) sur des parties de ladite deuxième portion de ladite première couche de polysilicium (29);
f) déposer une deuxième couche de polysilicium (31) ayant ledit deuxième type de conductibilité, ladite deuxième couche de polysilicium (31) comprenant une première portion au-dessus de ladite première région de formation d'un élément à semiconducteur (22), en contact avec ladite région d'émetteur (25e) par l'intermédiaire d'une deuxième ouverture dans ladite couche de dioxyde de silicium (30), et une deuxième portion formée sur ladite couche diélectrique (37);
g) former des conducteurs de base (25B) et d'émetteur (25E) connectés auxdites premières portions desdites première et deuxième couches de polysilicium (29, 31), respectivement; et
h) former une pluralité de premières électrodes espacées (39a) sur des parties exposées de ladite deuxième portion de ladite première couche de polysilicium (29) et une pluralité de deuxièmes électrodes espacées (40a) sur ladite deuxième portion de ladite deuxième couche de polysilicium (31), lesdites première et deuxième pluralités d'électrodes (39a, 40a) étant en contact avec des première et deuxième résistances empilées (39, 40) formées par les deuxièes portions des première et deuxième couches de polysilicium, respectivement.

3. Procédé selon la revendication 2,
caractérisé en ce que:
a) ladite première couche de polysilicium (29) comprend une troisième portion formée à l'extérieur de ladite région de formation d'un élément à semiconducteur (22) au-dessus d'un autre desdits sillons isolants (21);
b) ladite couche diélectrique (37) est également formée sur des parties de ladite troisième portion de ladite première couche de polysilicium (29);
c) ladite deuxième couche de polysilicium (31) comprend une troisième portion formée sur ladite couche diélectrique (37); et en ce que:
d) une troisième électrode (38a) est formée sur une partie exposée de ladite troisième portion de ladite première couche de polysilicium (29), et une quatrième électrode (38b) est formée sur ladite troisième portion de ladite deuxième couche de polysilicium (31), lesdites troisième et quatrième électrodes (38a, 38b) coopérant pour former un condensateur (38).

4. Procédé selon l'une des revendications 1 à 3,
caractérisé en ce qu'il est prévu un intervalle entre sillons qui est égal à une taille prédéterminée d'élément minimal.

5. Procédé selon la revendication 4,
caractérisé en ce que ledit intervalle entre sillons est approximativement de 10 µm.

6. Procédé selon la revendication 5,
caractérisé en ce qu'un élément à semiconducteur de taille plus grande que ladite taille d'élément minimal est formé en formant une pluralité de régions de formation des éléments à semiconducteur (22) voisines entre lesquelles un sillon isolant (21) n'est pas formé.
